# EUROPEAN PATENT APPLICATION

(11) **EP 3 489 274 A1**
(43) Date of publication of application: **29.05.2019**
(21) Application number: 17830932.4
(22) Date of filing: 13.07.2017
(51) Int. Cl.: C08G 61/00, H01L 51/50

(54) **POLYMER COMPOUND PRODUCTION METHOD**

(30) Priority: 21.07.2016 JP 2016143111
(71) Applicant: Sumitomo Chemical Company Limited, Tokyo 104-8260 (JP)
(72) Inventor: KASHIMA, Ken, Osaka-shi Osaka 554-8558 (JP); SHINODA, Hiroshi, Osaka-shi Osaka 554-8558 (JP); MATSUSHITA, Shohei, Osaka-shi Osaka 554-8558 (JP)
(74) Representative: J A Kemp
(86) International application number: PCT/JP2017/025537
(87) International publication number: WO 2018/016413

(57) **Abstract**

To provide a polymer compound production method capable of efficiently producing a polymer compound in which the content of a halogen atom and the content of a hydroxyl group are sufficiently reduced.

A production method of a polymer compound containing a constitutional unit represented by the formula (1), a constitutional unit represented by the formula (2) and a structure represented by the formula (3), comprising a first step of reacting a compound represented by the formula (M-1) and a compound represented by the formula (M-2), in the presence of a solvent, a base and a first palladium compound, to obtain a reaction product and a second step of reacting the above-described reaction product and a compound represented by the formula (M-3), in the presence of a second palladium compound different from the first palladium compound, to obtain a polymer compound:

Z¹-Ar¹-Z² (M-1)

Z³-Ar²-Z⁴ (M-2)

Ar³-Z⁵ (M-3)

[wherein, Ar¹ and Ar² represent an arylene group or the like, and Ar³ represents an aryl group or the like. Z¹ to Z⁵ represent a group selected from Group A of substituent and Group B of substituent.]
<Group A of substituent>
a chlorine atom and the like:
<Group B of substituent>
a group represented by -B(OR^{C2})₂ (wherein, R^{C2} represents a hydrogen atom or the like.):

⁅Ar¹⁆ (1)

⁅Ar²⁆ (2)

-Ar³ (3)

## Description

### Technical Field

The present invention relates to a production method of a polymer compound.

### Background Art

When a polymer compound is used as the material of an electronic device such as an organic electroluminescent device and the like, a halogen atom and a hydroxyl group remaining in the polymer compound may cause deterioration of the characteristics of the electronic device in some cases. For that reason, a polymer compound in which the content of a halogen atom and the content of a hydroxyl group are reduced is required.

It is known that a polymer compound in which the content of a halogen atom is reduced can be produced, for example, by subjecting a polymer compound containing a remaining halogen atom to a coupling reaction repeatedly or to dehalogenation by a catalytic reaction (Patent Documents 1, 2).

Further, it is known that a polymer compound in which the content of a hydroxyl group is reduced is produced, for example, by condensation-polymerizing monomers as raw materials under an oxygen concentration of less than 0.05%, or subjecting a polymer compound obtained by condensation polymerization to an alumina treatment or a copper salt treatment (Patent Document 3) .

### Prior Art Document

### Patent Document

Patent Document 1: Japanese Unexamined Patent Application Publication No. 2015-92571
Patent Document 2: Japanese Unexamined Patent Application Publication No. 2015-13832
Patent Document 3: International Publication WO 2015/037521

### Summary of the Invention

### Problem to be Solved by the Invention

In the methods described above, however, the content of at least one of a halogen atom and a hydroxyl group cannot be sufficiently reduced or the treatment for reducing a halogen atom and a hydroxyl group is required to be conducted repeatedly in some cases, thus, it was difficult to efficiently produce a polymer compound in which the content of a halogen atom and the content of a hydroxyl group are reduced sufficiently.

Then, the present invention has an object of providing a polymer compound production method which can efficiently produce a polymer compound in which the content of a halogen atom and the content of a hydroxyl group are sufficiently reduced.

### Means for Solving the Problem

The present invention provides the following [1] to [6].
[1] A production method of a polymer compound having a constitutional unit represented by the formula (1), a constitutional unit represented by the formula (2) and a structure represented by the formula (3), comprising
   a first step of reacting a compound represented by the formula (M-1) and a compound represented by the formula (M-2), in the presence of a solvent, a base and a first palladium compound, to obtain a reaction product, and
   a second step of reacting the above-described reaction product and a compound represented by the formula (M-3), in the presence of a second palladium compound different from the first palladium compound, to obtain a polymer compound:
   [Chemical Formula 1]

   **z¹-Ar¹-Z² (M-1) Z³-Ar²-z⁴** **(M-2)**

   [wherein,
   Ar¹ and Ar² each independently represent an arylene group, a divalent heterocyclic group or a divalent aromatic amine residue, and these groups optionally have a substituent.
   Z¹, Z², Z³ and Z⁴ each independently represent a group selected from Group A of substituent and Group B of substituent. At least one of Z¹, Z², Z³ and Z⁴ is a group selected from Group A of substituent and at least one of them is a group selected from Group B of substituent.]

### <Group A of substituent>

A chlorine atom, a bromine atom, an iodine atom and a group represented by -O-S(=O)₂R^{C1} (wherein, R^{C1} represents an alkyl group or an aryl group, and these groups optionally have a substituent.).

### <Group B of substituent>

A group represented by -B(OR^{C2})₂ (wherein, R^{C2} represents a hydrogen atom, an alkyl group or an aryl group, and these groups optionally have a substituent. A plurality of R^{C2} may be the same or different and may be combined together to form a ring together with oxygen atoms to which they are attached.).
[Chemical Formula 2]

**Ar³-Z⁵** **(M-3)**

[wherein, Ar³ represents an aryl group or a monovalent heterocyclic group, and these groups optionally have a substituent. Z⁵ represents a group selected from Group A of substituent and Group B of substituent.]
[Chemical Formula 3]

**⁅Ar¹⁆** **(1)**

**⁅Ar²⁆** **(2)**

**-Ar³** **(3)**

[wherein, Ar¹, Ar² and Ar³ represent the same meaning as described above.].
[2] The polymer compound production method according to [1], wherein
   if the molecular weight of the reaction product obtained in the first step is measured every 30 minutes from the start of the reaction, the first step is terminated when the variation of the molecular weight of the reaction product obtained in the measurement 30 minutes earlier compared to the molecular weight of the reaction product obtained in the immediately preceding measurement becomes 40% or less.
[3] The polymer compound production method according to [1] or [2], wherein
   the above-described first palladium compound and second palladium compound are each independently a palladium(0) complex or a palladium(II) complex.
[4] The polymer compound production method according to any one of [1] to [3], wherein
   the above-described second palladium compound has a phosphine ligand.
[5] The polymer compound production method according to any one of [1] to [4], wherein
   the above-described divalent aromatic amine residue is a group represented by the formula (X): 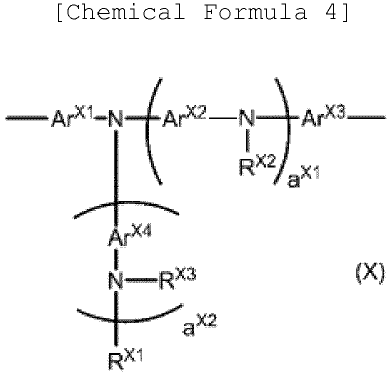 [wherein,
   a^{X1} and a^{X2} each independently represent an integer of 0 to 2.
   Ar^{X1}, Ar^{X2}, Ar^{X3} and Ar^{X4} each independently represent an arylene group, a divalent heterocyclic group or a divalent group in which an arylene group and a divalent heterocyclic group are bonded directly, and these groups optionally have a substituent. When a plurality of Ar^{X2} and Ar^{X4} are present, they may be the same or different at each occurrence.
   R^{X1}, R^{X2} and R^{X3} each independently represent a hydrogen atom, an alkyl group, a cycloalkyl group, an aryl group, a monovalent heterocyclic group or a metal complex-containing group, and these groups optionally have a substituent. When a plurality of R^{X2} and R^{X3} are present, they may be the same or different at each occurrence.].
[6] The polymer compound production method according to any one of [1] to [5], wherein
   the second step is conducted in the presence of the first palladium used in the first step.

### Modes for Carrying Out the Invention

Preferable embodiments of the present invention will be illustrated below.

### <Explanation of common terms>

Hereinafter, terms commonly used in the present specification have the following meanings unless otherwise stated.

Me represents a methyl group, Et represents an ethyl group, i-Pr represents an isopropyl group, n-Bu represents a n-butyl group and t-Bu represents a tert-butyl group.

In the present specification, the hydrogen atom may be a light hydrogen atom or a heavy hydrogen atom.

The term "polymer compound" denotes a polymer having molecular weight distribution and having a polystyrene-equivalent number-average molecular weight (Mn) of 1 × 10³ to 1 × 10⁸. The amount of constitutional units contained in the polymer compound is 100 mol% in total.

The term "constitutional unit" means a unit occurring once or more times in a polymer compound.

The "alkyl group" may be any of linear, branched or cyclic. The number of carbon atoms of the linear alkyl group, not including the number of carbon atoms of the substituent, is usually 1 to 50, preferably 3 to 30, more preferably 4 to 20. The number of carbon atoms of the branched or cyclic alkyl group, not including the number of carbon atoms of the substituent, is usually 3 to 50, preferably 3 to 30, more preferably 4 to 20.

The alkyl group optionally has a substituent, and examples thereof include unsubstituted alkyl groups such as a methyl group, an ethyl group, a n-propyl group, an isopropyl group, a n-butyl group, an isobutyl group, a tert-butyl group, a n-pentyl group, an isoamyl group, a 2-ethylbutyl group, a n-hexyl group, a cyclohexyl group, a n-heptyl group, a cyclohexylmethyl group, a cyclohexylethyl group, a n-octyl group, a 2-ethylhexyl group, a 3-n-propylheptyl group, a n-decyl group, a 3,7-dimethyloctyl group, a 2-ethyloctyl group, a 2-n-hexyl-decyl group, a n-dodecyl group and the like; and substituted alkyl groups such as a trifluoromethyl group, a pentafluoroethyl group, a perfluorobutyl group, a perfluorohexyl group, a perfluorooctyl group, a 3-phenylpropyl group, a 3-(4-methylphenyl)propyl group, a 3-(3,5-di-n-hexylphenyl)propyl group, a 6-ethyloxyhexyl group and the like.

The "alkylene group" denotes a divalent group obtained by removing one hydrogen atom from the above-described "alkyl group". The "alkylene group" may be any of linear, branched or cyclic. The number of carbon atoms of the linear alkylene group, not including the number of carbon atoms of the substituent, is usually 1 to 50, preferably 2 to 30, more preferably 2 to 20, further preferably 2 to 10, especially preferably 2 to 5. The number of carbon atoms of the branched or cyclic alkylene group, not including the number of carbon atoms of the substituent, is usually 3 to 50, preferably 4 to 30, more preferably 5 to 20.

The alkylene group optionally has a substituent, and examples thereof include a dimethylene group, a trimethylene group and a tetramethylene group.

The "aromatic compound" means an aromatic hydrocarbon compound and an aromatic heterocyclic compound.

The "aryl group" means an atomic group remaining after removing from an aromatic hydrocarbon one hydrogen atom bonding directly to a carbon atom constituting the ring. The number of carbon atoms of the aryl group, not including the number of carbon atoms of the substituent, is usually 6 to 60, preferably 6 to 20, more preferably 6 to 10.

The aryl group optionally has a substituent, and examples thereof include a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group and a 4-phenylphenyl group, and groups obtained by substituting a hydrogen atom in these groups with an alkyl group, an alkoxy group, an aryl group, a fluorine atom or the like.

The "alkoxy group" may be any of linear, branched or cyclic. The number of carbon atoms of the linear alkoxy group, not including the number of carbon atoms of the substituent, is usually 1 to 40, preferably 4 to 10. The number of carbon atoms of the branched or cyclic alkoxy group, not including the number of carbon atoms of the substituent, is usually 3 to 40, preferably 4 to 10.

The alkoxy group optionally has a substituent, and examples thereof include a methoxy group, an ethoxy group, a n-propyloxy group, an isopropyloxy group, a n-butyloxy group, an isobutyloxy group, a tert-butyloxy group, a n-pentyloxy group, a n-hexyloxy group, a cyclohexyloxy group, a n-heptyloxy group, a n-octyloxy group, a 2-ethylhexyloxy group, a n-nonyloxy group, a n-decyloxy group, a 3,7-dimethyloctyloxy group and a lauryloxy group.

The number of carbon atoms of the "aryloxy group", not including the number of carbon atoms of the substituent, is usually 6 to 60, preferably 7 to 48.

The aryloxy group optionally has a substituent, and examples thereof include a phenoxy group, a 1-naphthyloxy group, a 2-naphthyloxy group, a 1-anthracenyloxy group, a 9-anthracenyloxy group and a 1-pyrenyloxy group, and groups obtained by substituting a hydrogen atom in these groups with an alkyl group, an alkoxy group, a fluorine atom or the like.

The "substituted amino group" is an amino group having two substituents. The substituent which the amino group has is preferably an alkyl group, an aryl group or a monovalent heterocyclic group. The substituted amino group includes, for example, a dialkylamino group and a diarylamino group.

The substituted amino group includes, for example, a dimethylamino group, a diethylamino group, a diphenylamino group, a bis(4-methylphenyl)amino group, a bis(4-tert-butylphenyl)amino group and a bis(3,5-di-tert-butylphenyl)amino group.

The "alkenyl group" may be any of linear, branched or cyclic. The number of carbon atoms of the linear alkenyl group, not including the number of carbon atoms of the substituent, is usually 2 to 30, preferably 3 to 20. The number of carbon atoms of the branched or cyclic alkenyl group, not including the number of carbon atoms of the substituent, is usually 3 to 30, preferably 4 to 20.

The alkenyl group optionally has a substituent, and examples thereof include a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group and a 7-octenyl group, and these groups having a substituent.

The "alkynyl group" may be any of linear, branched or cyclic. The number of carbon atoms of the alkynyl group, not including the number of carbon atoms of the substituent, is usually 2 to 20, preferably 3 to 20. The number of carbon atoms of the branched or cyclic alkynyl group, not including the number of carbon atoms of the substituent, is usually 4 to 30, preferably 4 to 20.

The alkynyl group optionally has a substituent, and examples thereof include an ethynyl group, a 1-propynyl group, a 2-propynyl group, a 2-butynyl group, a 3-butynyl group, a 3-pentynyl group, a 4-pentynyl group, a 1-hexynyl group and a 5-hexynyl group, and these groups having a substituent.

The "arylene group" means an atomic group remaining after removing from an aromatic hydrocarbon two hydrogen atoms bonding directly to carbon atoms constituting the ring. The number of carbon atoms of the arylene group, not including the number of carbon atoms of the substituent, is usually 6 to 60, preferably 6 to 30, more preferably 6 to 18.

The arylene group optionally has a substituent, and examples thereof include a phenylene group, a naphthalenediyl group, an anthracenediyl group, a phenanthrenediyl group, a dihydrophenanthrenediyl group, a naphthacenediyl group, a fluorenediyl group, a pyrenediyl group, a perylenediyl group and a chrysenediyl group, and these groups having a substituent, preferably, groups represented by the formula (A-1) to the formula (A-20). The arylene group includes groups obtained by bonding a plurality of these groups. 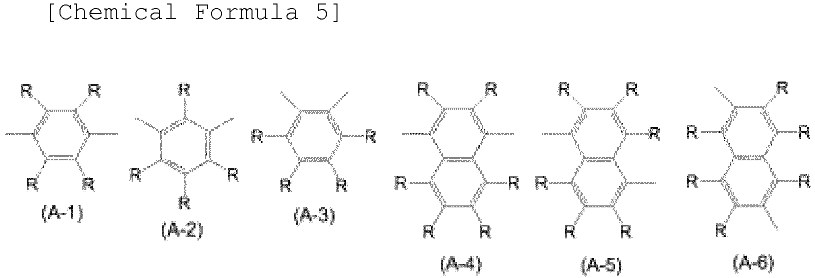 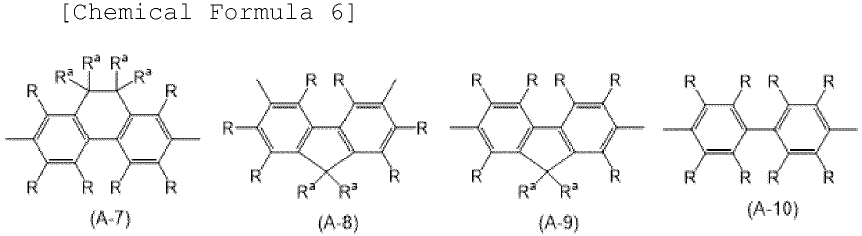 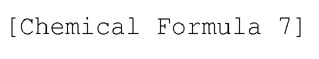 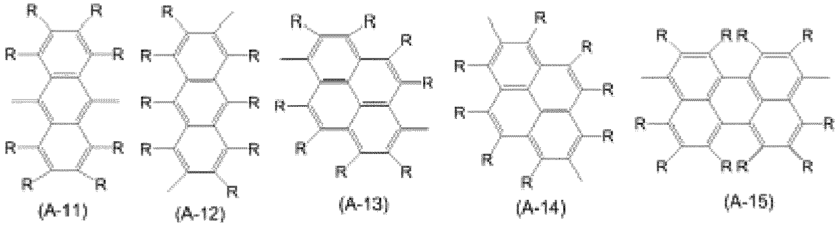 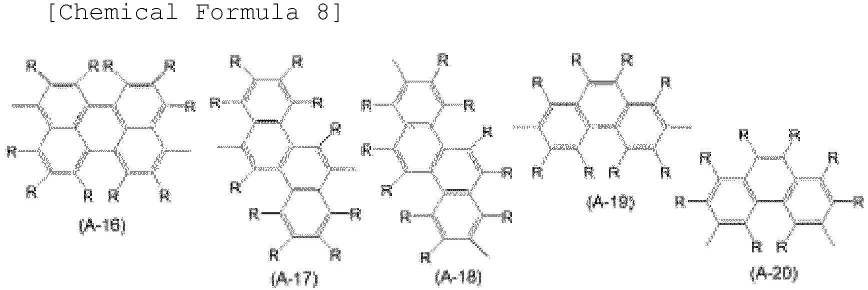 [wherein, R and R^{a} each independently represent a hydrogen atom, an alkyl group or an aryl group. A plurality of R and R^{a} may be the same or different at each occurrence. Adjacent R^{a} may be combined together to form a ring together with carbon atoms to which they are attached.]

The "p-valent heterocyclic group" (p represents an integer of 1 or more.) means an atomic group remaining after removing from a heterocyclic compound p hydrogen atoms among hydrogen atoms bonding directly to carbon atoms or hetero atoms constituting the ring. Of the p-valent heterocyclic groups, preferable is a "p-valent aromatic heterocyclic group" which is an atomic group remaining after removing from an aromatic heterocyclic compound p hydrogen atoms among hydrogen atoms bonding directly to carbon atoms or hetero atoms constituting the ring.

The "aromatic heterocyclic compound" denotes a compound in which the hetero ring itself shows aromaticity such as oxadiazole, thiadiazole, thiazole, oxazole, thiophene, pyrrole, phosphole, furan, pyridine, pyrazine, pyrimidine, triazine, pyridazine, quinoline, isoquinoline, carbazole, dibenzosilole, dibenzophosphole and the like, and a compound in which an aromatic ring is condensed to a hetero ring even if the hetero ring itself does not show aromaticity such as phenoxazine, phenothiazine, dibenzoborole, dibenzosilole, benzopyran and the like.

The number of carbon atoms of the p-valent heterocyclic group, not including the number of carbon atoms of the substituent, is usually 2 to 60, preferably 4 to 20.

The p-valent heterocyclic group optionally has a substituent.

The monovalent heterocyclic group includes, for example, a thienyl group, a pyrrolyl group, a furyl group, a pyridyl group, a piperidyl group, a quinolyl group, an isoquinolyl group, a pyrimidinyl group and a triazinyl group, and groups obtained by substituting a hydrogen atom in these groups with an alkyl group, an alkoxy group or the like.

The divalent heterocyclic group optionally has a substituent, and examples thereof include divalent groups obtained by removing from pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole or triazole two hydrogen atoms among hydrogen atoms bonding directly to carbon atoms or hetero atoms constituting the ring, preferably, groups represented by the formula (A-21) to the formula (A-52). The divalent heterocyclic group includes groups obtained by bonding a plurality of these groups. 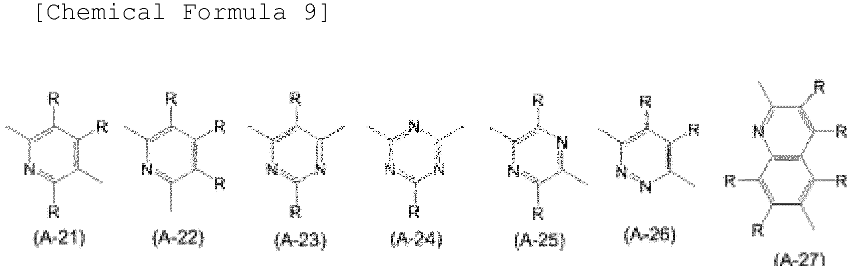 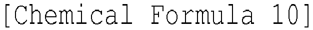 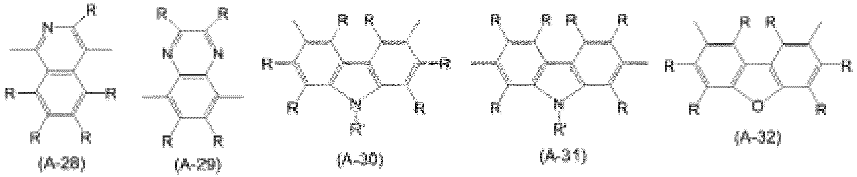 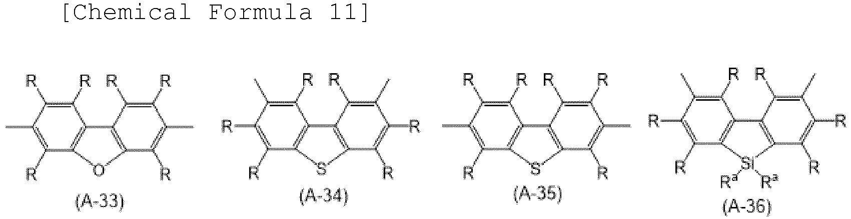 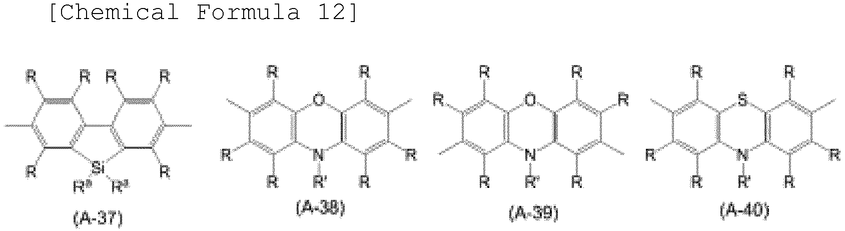 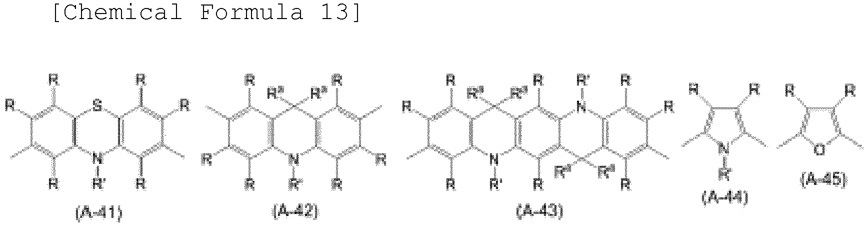 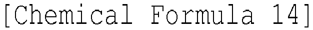 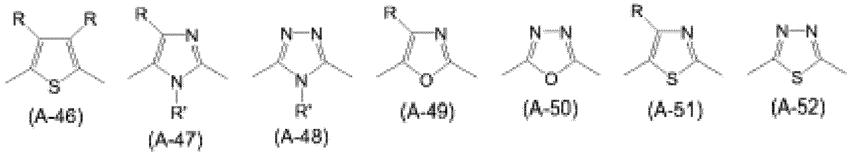 [wherein, R and R^{a} represent the same meaning as described above . R' represents an alkyl group or an aryl group. When a plurality of R' are present, they may be the same or different.]

The "crosslinkable group" is a group capable of generating a new bond by being subjected to heating treatment, ultraviolet irradiation treatment, radical reaction and the like, and preferably a group represented by any of the formula (B1) to the formula (B-17). 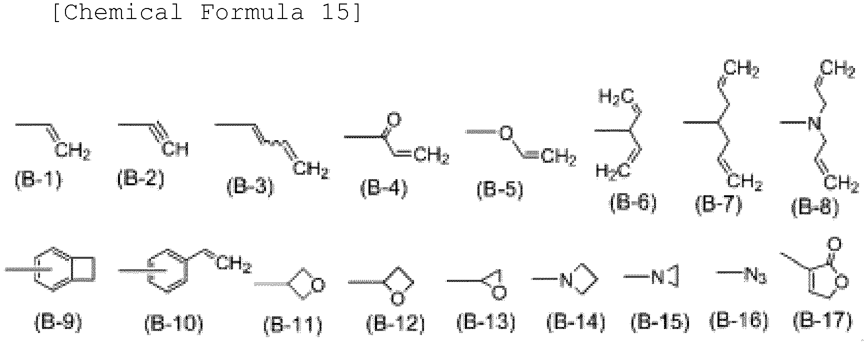 [wherein, these groups optionally have a substituent.]

The "substituent" means a fluorine atom, a cyano group, an alkyl group, an aryl group, a monovalent heterocyclic group, an alkoxy group, an aryloxy group, a substituted amino group, an alkenyl group or an alkynyl group. The substituent may also be a crosslinkable group.

The group represented by -O-S(=O)₂R^{C1} includes, for example, a methanesulfonyloxy group, an ethanesulfonyloxy group and a trifluoromethanesulfonyl group.

The group represented by -B(OR^{C2})₂ includes, for example, groups represented by the following formulae.

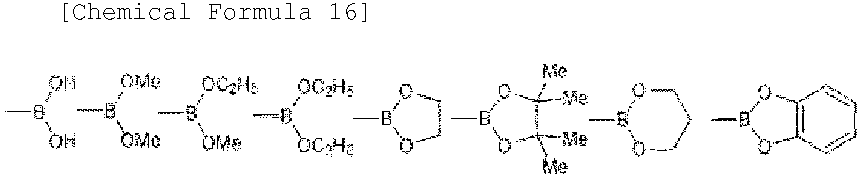

### <Production method of polymer compound>

Next, the polymer compound production method of the present embodiment will be explained.

### [First step]

The first step is a step of reacting a compound represented by the formula (M-1) and a compound represented by the formula (M-2), in the presence of a solvent, a base and a first palladium compound, to obtain a reaction product.

It is preferable, in the first step, that a compound represented by the formula (M-1), a compound represented by the formula (M-2) and a first palladium compound are mixed in a reaction vessel, then, the oxygen concentration in the reaction vessel is reduced by purging with an inert gas.

In the first step, at least one selected from the group consisting of a compound represented by the formula (M-1), a compound represented by the formula (M-2), a solvent and a base may be further added, if necessary.

The ratio of a group selected from Group B of substituent is usually 1 to 80 mol%, preferably 10 to 60 mol%, more preferably 30 to 50 mol%, with respect to 100 mol% of the total amount of Z¹, Z², Z³ and Z⁴.

### First palladium compound

The first palladium compound is usually a palladium catalyst. The above-described palladium catalyst may be a uniform transition metal complex catalyst or a non-uniform transition metal complex catalyst, and is preferably a uniform transition metal complex catalyst.

The first palladium compound includes, for example, compounds represented by the formula (a) to the formula (d). 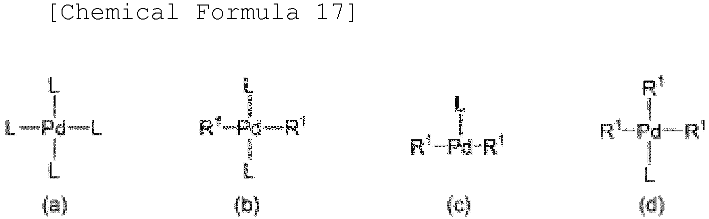 (wherein, L represents a ligand having an unpaired electron pair. R¹ represents a hydrogen atom, a halogen atom, an alkyl group, an aryl group, a monovalent heterocyclic group or a sulfonyloxy group. A plurality of L may be the same or different. A plurality of R¹ may be the same or different. In the formula (a) and the formula (b), two groups L may be combined together to form a ring. In the formula (b), L and R¹ may be combined together to form a ring. In the formula (d), two groups R¹ may be combined together to form a ring.)

The first palladium compound is preferably a compound represented by the formula (a), the formula (b) or the formula (d) .

The ligand having an unpaired electron pair is preferably a phosphine ligand, a carbene ligand or an aromatic heterocyclic ligand, more preferably a phosphine ligand.

The phosphine ligand includes, for example, ligands represented by the formula (5). 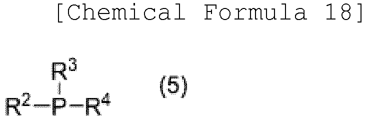 (wherein, R², R³ and R⁴ each independently represent an alkyl group, an aryl group or a monovalent heterocyclic group, and these groups optionally have a substituent.)

The ligand represented by the formula (5) includes, for example, triarylphosphine type monodentate ligands such as triphenylphosphine, tri-o-tolylphosphine, tri-m-tolylphosphine, tri-p-tolylphosphine, tris(pentafluorophenyl)phosphine, tris(p-fluorophenyl)phosphine, tris(o-methoxyphenyl)phosphine, tris(m-methoxyphenyl)phosphine, tris(p-methoxyphenyl)phosphine, tris(2,4,6-trimethoxyphenyl)phosphine, tri-2-furylphosphine and the like; alkyldiarylphosphine type monodentate ligands such as cyclohexyldiphenylphosphine and the like; dialkylarylphosphine type monodentate ligands such as 2-(dicyclohexylphosphino)biphenyl, 2-(di-tert-butylphosphino)biphenyl, 2-di-tert-butylphosphino-2'-methylbiphenyl, 2-dicyclohexylphosphino-2' ,6'-dimethoxybiphenyl, 2-(dicyclohexylphosphino)-2'-(N,N-dimethylamino)biphenyl, 2-dicyclohexylphosphino-2'-methylbiphenyl, 2-dicyclohexylphosphino-2',4',6'-triisopropylbiphenyl, dicyclopentyl(2-methoxyphenyl)phosphine, dicyclopentyl(2,6-dimethoxyphenyl)phosphine, di-tert-butyl(3,5-di-tert-butylphenyl)phosphine, N-phenyl-2-(di-tert-butylphosphino)pyrrole, N-phenyl-2-(di-tert-butylphosphino)indole, N-phenyl-2-(dicyclohexylphosphino)pyrrole and the like; and trialkylphosphine type monodentate ligands such as tricyclohexylphosphine, tri-tert-butylphosphine, di(1-adamantyl)-n-butylphosphine and the like, and preferable are triarylphosphine type monodentate ligands, dialkylarylphosphine type monodentate ligands and alkyldiarylphosphine type monodentate ligands, more preferable are triarylphosphine type monodentate ligands and dialkylarylphosphine type monodentate ligands.

The carbene ligand includes, for example, ligands represented by the formula (6) or the formula (7). 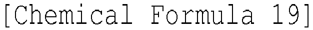 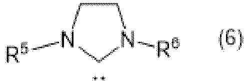 (wherein, R⁵ and R⁶ each independently represent an alkyl group, an aryl group or a monovalent heterocyclic group, and these groups optionally have a substituent.) 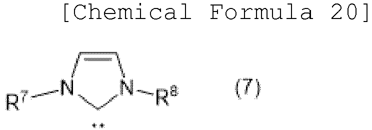 (wherein, R⁷ and R⁸ each independently represent an alkyl group, an aryl group or a monovalent heterocyclic group, and these groups optionally have a substituent.)

The carbene ligand includes, for example, 1,3-bis(2,6-diisopropylphenyl)imidazol-2-ylidene, 1,3-bis(2,6-diisopropylphenyl)imidazolidin-2-ylidene, 1,3-bis(2,4,6-trimethylphenyl)imidazol-2-ylidene, 1,3-bis(2,4,6-trimethylphenyl)imidazolidin-2-ylidene, 1,3-dimesitylimidazol-2-ylidene, 1,3-dimesitylimidazolidin-2-ylidene, 1,3-di-tert-butylimidazol-2-ylidene, 1,3-di-tert-butylimidazolidin-2-ylidene, 1,3-di(1-adamantyl)imidazol-2-ylidene, 1,3-di(1-adamantyl)imidazolidin-2-ylidene, 1,3-diisopropylimidazol-2-ylidene, 1,3-diisopropylimidazolidin-2-ylidene, 1,3-di-tert-butylimidazol-2-ylidene, 1,3-di-tert-butylimidazolidin-2-ylidene, 1,3-dicyclohexylimidazolidin-2-ylidene and 1,3-dicyclohexylimidazol-2-ylidene.

The aromatic heterocyclic ligand includes, for example, oxadiazole, thiadiazole, thiazole, oxazole, thiophene, pyrrole, phosphole, furan, pyridine, pyrazine, pyrimidine, triazine, pyridazine, quinoline, isoquinoline, carbazole, dibenzosilole and dibenzophosphole, and preferable are pyridine, pyrazine, pyrimidine, triazine and pyridazine, more preferable is pyridine. These ligands optionally have a substituent.

The ligand in which two groups L are combined together to form a ring in the formula (a) and the formula (b) includes, for example, ligands represented by the formula (8). 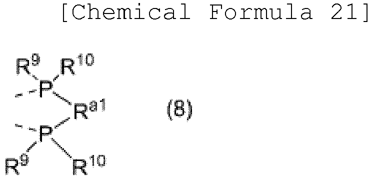 (wherein, R⁹ and R¹⁰ each independently represent an alkyl group, an aryl group or a monovalent heterocyclic group, and these groups optionally have a substituent. R^{a1} represents an alkylene group or an arylene group, and these groups optionally have a substituent. The broken line represents a point binding to a palladium atom.)

The ligand represented by the formula (8) includes, for example, 1,2-bis(diphenylphosphino)ethane, 1,3-bis(diphenylphosphino)propane, 2,2'-bis(diphenylphosphino)-1,1'-binaphthyl and 4,5-bis(diphenylphosphino)-9,9-dimethylxanthene

The structure in which two groups R¹ are combined together to form a ring in the formula (d) includes, for example, structures represented by the formula (9) to the formula (11) . 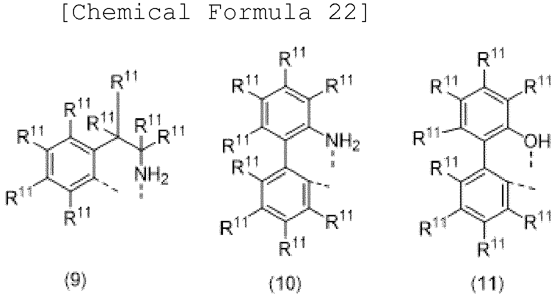 (wherein, R¹¹ represents a hydrogen atom, a halogen atom, an alkyl group, a hydroxyl group, a alkoxy group, a aryloxy group or an aryl group, and these groups optionally have a substituent. A plurality of R¹¹ may be the same or different. The broken line represents a point binding to a palladium atom.)

The structure in which L and R¹ are combined together to form a ring in the formula (b) includes, for example, structures represented by the formula (12) or the formula (13). 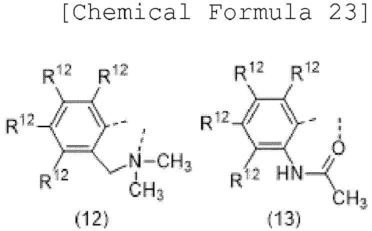 (wherein, R¹² represents a hydrogen atom, an alkyl group, an alkoxy group, an aryloxy group or an aryl group, and these optionally have a substituent. A plurality of R¹² may be the same or different. The broken line represents a point binding to a palladium atom.)

The first palladium compound includes, for example, palladium compounds having an triarylphosphine type monodentate ligand such as tetrakis(triphenylphosphine)palladium, dichlorobis[tri(o-tolyl)phosphine]palladium, dichlorobis[tris(2-methoxyphenyl)phosphine]palladium and the like; palladium compounds having an alkyldiarylphosphine type monodentate ligand such as dichlorobis(cyclohexyldiphenylphosphine)palladium and the like; palladium compounds having a dialkylaryl type monodentate ligand such as dichlorobis(2-dicyclohexylphosphino-2',6'-dimethoxybiphenyl )palladium, dichlorobis(2-dicyclohexylphosphino-2',4',6'-triisopropylbi phenyl)palladium, dichlorobis[dicyclopentyl(2-methoxyphenyl)phosphine]palladi um, dichlorobis[di-tert-butyl(3, 5-di-tert-butylphenyl)phosphine]palladium and the like; palladium compounds having a trialkylphosphine type monodentate ligand such as tetrakis(tricyclohexylphosphine)palladium, tetrakis(tri-tert-butylphosphine)palladium and the like; palladium compounds having a bidentate ligand such as dichloro[1,1'-bis(diphenylphosphino)ethane]palladium, dichloro[1,1'-bis(diphenylphosphino)propane]palladium, dichloro[2,2'-bis(diphenylphosphino)-1,1'-binaphthyl]pallad ium and the like; and palladium compounds having a carbene ligand such as dichloro[1,3-bis(2,6-diisopropylphenyl)imidazol-2-ylidene] ( 3-chloropyridyl)palladium, dichloro[1,3-bis(2,6-di-3-pentylphenyl)imidazol-2-ylidene] ( 3-chloropyridyl)palladium and the like, and preferable are palladium compounds having a triarylphosphine type monodentate ligand and palladium compounds having a dialkylaryl type monodentate ligand.

The first palladium compound may be obtained commercially, may be synthesized by a ligand substitution reaction with a palladium precursor such as Pd(OAc)₂, Pd(dba)₂, Pd₂(dba)₃ and the like, or may be synthesized by mixing a palladium precursor and a compound to be a ligand in the system.

The use amount of the first palladium compound is usually 0.00001 mol to 3 mol, preferably 0.00005 mol to 2 mol, more preferably 0.0001 mol to 2 mol, with respect to 1 mol of the total amount of a compound represented by the formula (M-1) and a compound represented by the formula (M-2).

The first palladium compound may be used singly or in combination of two or more kinds thereof.

### <Compound represented by the formula (M-1) and the formula (M-2)>

The arylene group represented by Ar¹ and Ar² is preferably a group represented by the formula (A-1), the formula (A-2), the formula (A-6), the formula (A-7), the formula (A-9), the formula (A-10), the formula (A-11), the formula (A-13) or the formula (A-19), more preferably a group represented by the formula (A-1) or the formula (A-9).

The divalent heterocyclic group represented by Ar¹ and Ar² is preferably a group represented by the formula (A-24), the formula (A-30) to the formula (A-33) or the formula (A-38) to the formula (A-42), more preferably a group represented by the formula (A-24).

Ar¹ and Ar² are each preferably an arylene group or a divalent aromatic amine residue.

a^{X1} and a^{X2} are each preferably an integer of 0 to 2, and it is more preferable that a^{X1} is 1 and a^{X2} is 0.

The arylene group represented by Ar^{X1} and Ar^{X3} is preferably a group represented by the formula (A-1) or the formula (A-9), more preferably a group represented by the formula (A-1).

The divalent heterocyclic group represented by Ar^{X1}, Ar^{X2}, Ar^{X3} and Ar^{X4} is preferably a group represented by the formula (A-21), the formula (A-22) or the formula (A-27) to the formula (A-46).

The arylene group represented by Ar^{X2} and Ar^{X4} is preferably a group represented by the formula (A-1), the formula (A-6), the formula (A-7), the formula (A-9) to the formula (A-11) or the formula (A-19), more preferably a group represented by the formula (A-1).

The divalent group in which an arylene group and a divalent heterocyclic group are bonded directly represented by Ar^{X1}, Ar^{X2}, Ar^{X3} and Ar^{X4} includes, for example, groups represented by the following formulae, and these optionally have a substituent. 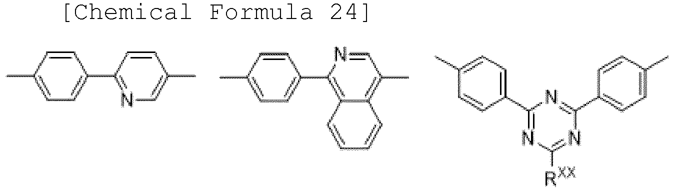 [wherein, R^{XX} represents a hydrogen atom, an alkyl group, an aryl group or a monovalent heterocyclic group, and these groups optionally have a substituent.]

R^{XX} is preferably an alkyl group or an aryl group, and these groups optionally have a substituent.

The alkyl group represented by R^{X1}, R^{X2} and R^{X3} is preferably a methyl group, an ethyl group, a n-propyl group, an isopropyl group, a n-butyl group, an isobutyl group, a tert-butyl group, a n-pentyl group, an isoamyl group, a 2-ethylbutyl group or a n-hexyl group.

The cycloalkyl group represented by R^{X1}, R^{X2} and R^{X3} is preferably a cyclopentyl group or a cyclohexyl group.

The aryl group represented by R^{X1}, R^{X2} and R^{X3} is preferably a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group or a 4-phenylphenyl group.

The monovalent heterocyclic group represented by R^{X1}, R^{X2} and R^{X3} is preferably a thienyl group, a pyrrolyl group, a furyl group, a pyridyl group, a piperidyl group, a quinolyl group, an isoquinolyl group, a pyrimidinyl group or a triazinyl group.

The metal complex-containing group represented by R^{X1}, R^{X2} and R^{X3} includes, for example, groups represented by any of the formula (MC-1) and the formula (MC-2). 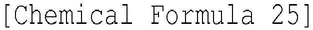 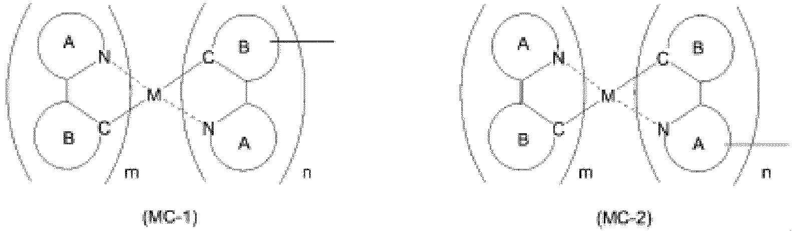 (wherein, M is an iridium atom or a platinum atom. m = 2 and n = 1 when M is an iridium atom, while m = 3 and n = 1, or m = 1 and n = 1 when M is a platinum atom. Ring A represents a nitrogen atom-containing cyclic structure optionally having a substituent. Ring B represents a carbon atom-containing cyclic structure optionally having a substituent.)
Ring A is preferably a hetero aromatic ring, more preferably a hetero aromatic ring having 2 to 9 carbon atoms.
Ring B is preferably an aromatic hydrocarbon ring, more preferably an aromatic hydrocarbon ring having 6 to 12 carbon atoms.

The metal complex-containing group optionally further has a substituent.

The compound represented by the formula (MC-1) includes, for example, compounds represented by the formula (MC-1a) to the formula (MC-1i), and compounds represented by the formula (MC-1b), the formula (MC-1c), the formula (MC-1d) or the formula (MC-1e) are preferable, a compound represented by the formula (MC-1e) is more preferable. A part or all of hydrogen atoms in these compounds may be substituted with substituents, and a plurality of substituents may be combined together to form a ring.

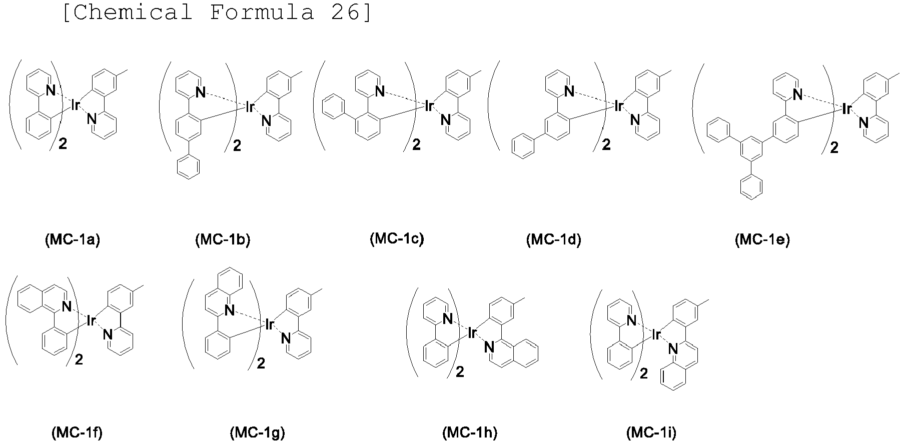

The compound represented by the formula (MC-2) includes, for example, compounds represented by the formula (MC-2a) to the formula (MC-2k), and compounds represented by the formula (MC-2b), the formula (MC-2c), the formula (MC-2d) or the formula (MC-2e) are preferable, a compound represented by the formula (MC-2e) is more preferable. A part or all of hydrogen atoms in these compounds may be substituted with substituents, and a plurality of substituents may be combined together to form a ring.

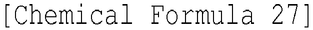

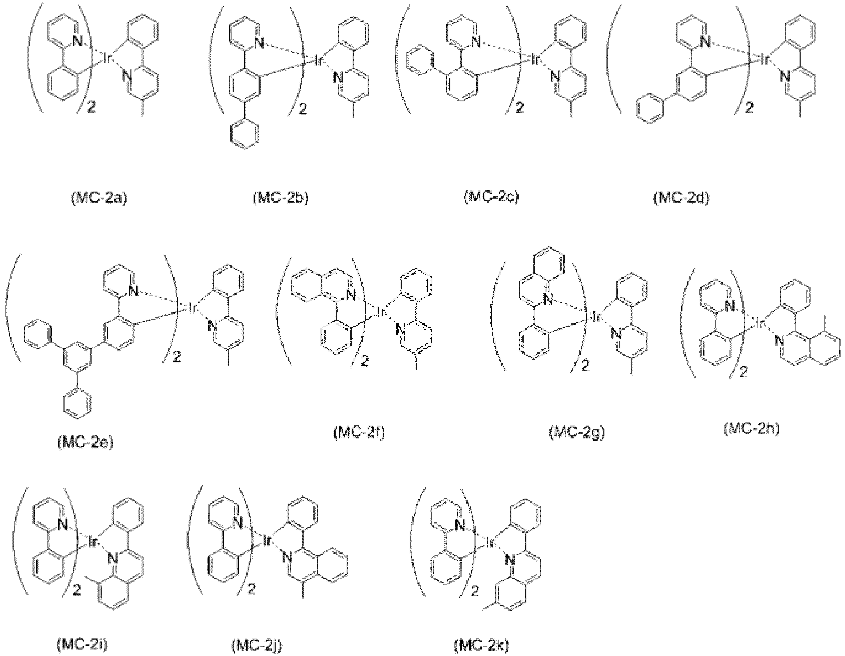

R^{X1}, R^{X2} and R^{X3} are each preferably a hydrogen atom, an alkyl group, a cycloalkyl group, an aryl group or a monovalent heterocyclic group, more preferably an aryl group.

Regarding Z¹, Z², Z³ and Z⁴, the group selected from Group A of substituent is preferably a chlorine atom, a bromine atom or a group represented by -O-S (=O) ₂R^{C1}, more preferably a bromine atom and the group selected from Group B of substituent is preferably a boronic acid residue or a boronic acid pinacol ester residue, more preferably a boronic acid pinacol ester residue.

The compounds represented by the formula (M-1) and the formula (M-2) are commercially available products or can be produced according to any known method.

The compounds represented by the formula (M-1) and the formula (M-2) may each be used singly or in combination of two or more kinds thereof.

The compounds represented by the formula (M-1) and the formula (M-2) include, for example, compounds represented by the formula (1-11) to the formula (1-46), the formula (X1-1) to the formula (X1-19) and the formula (Y-11) to the formula (Y-19). 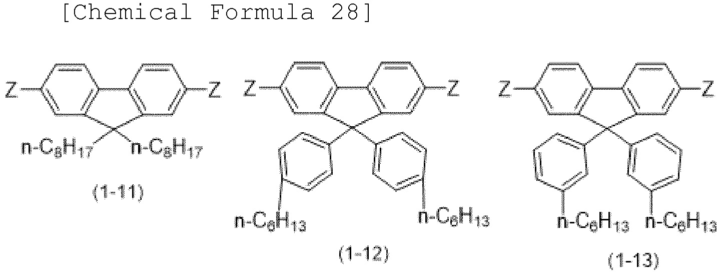 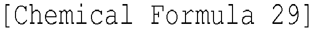 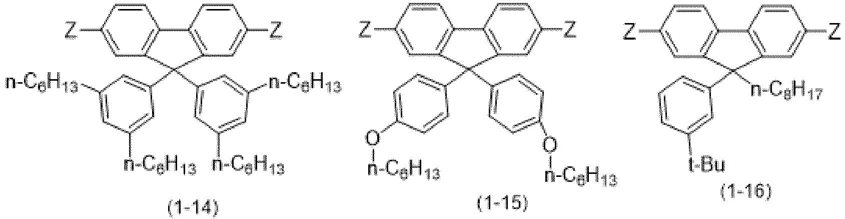 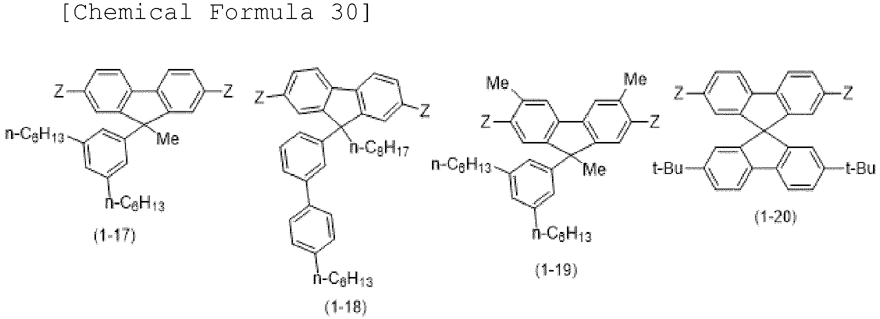 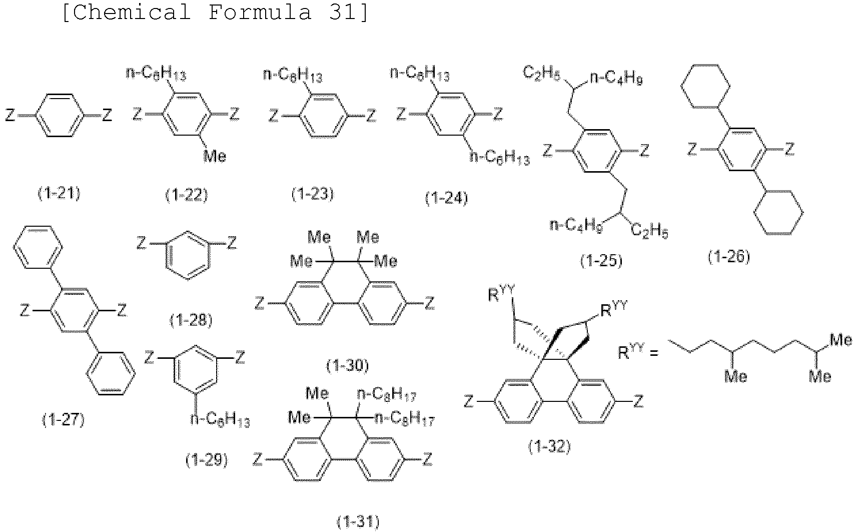 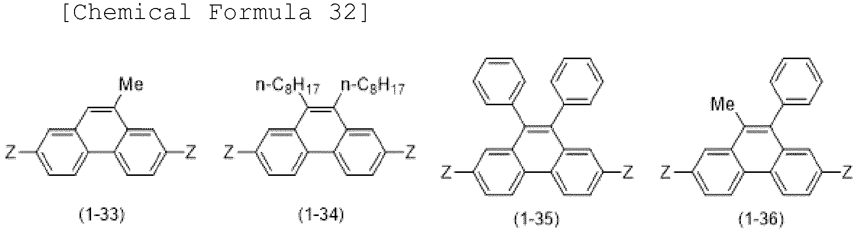 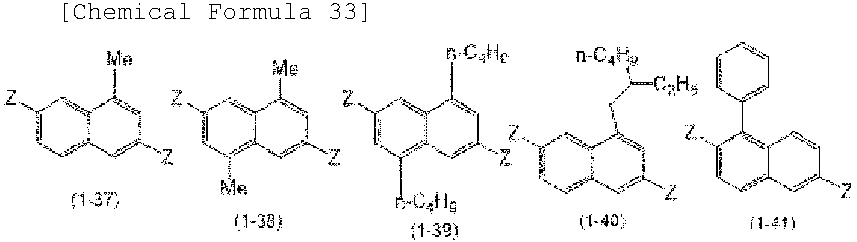 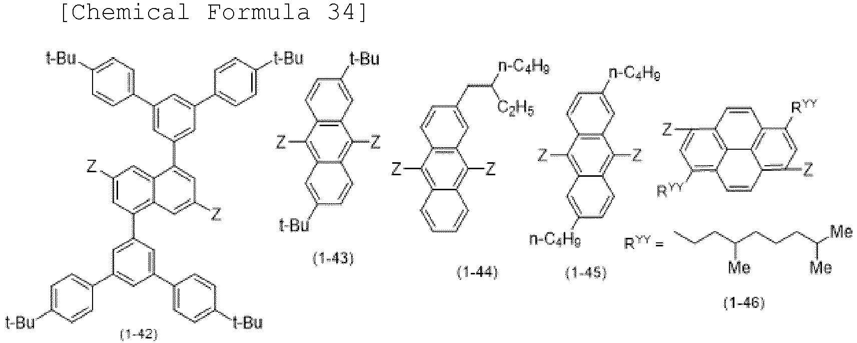 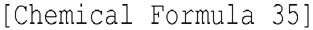 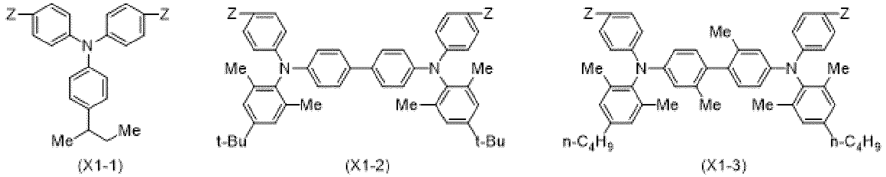 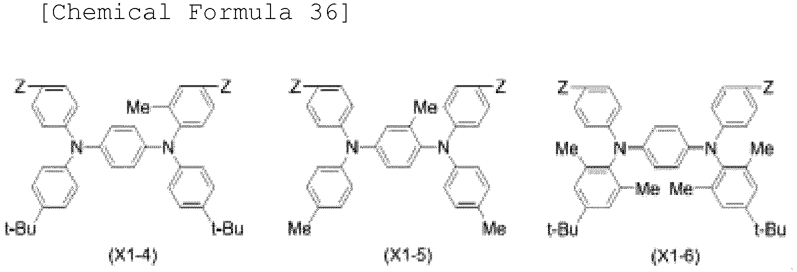 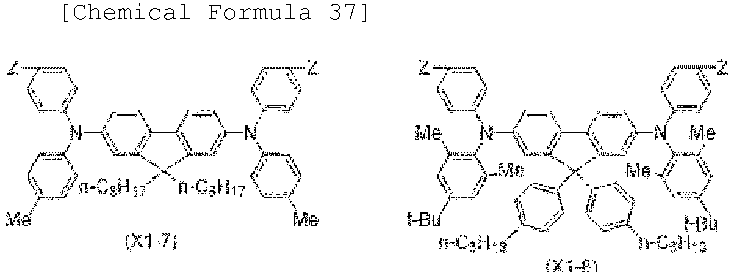 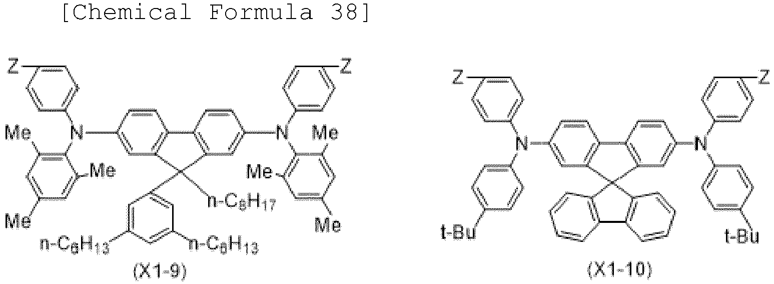 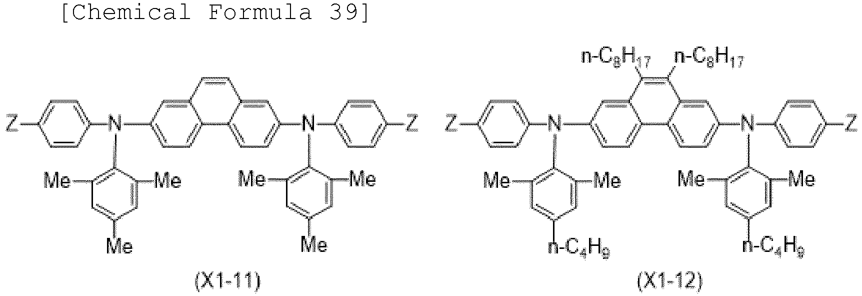 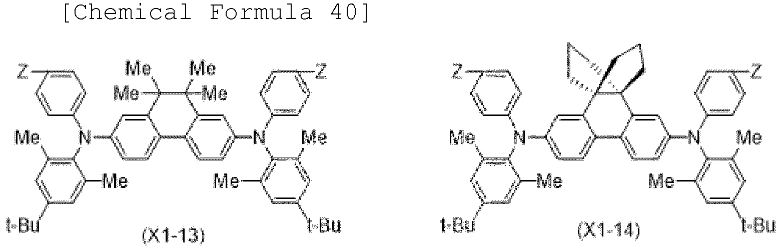 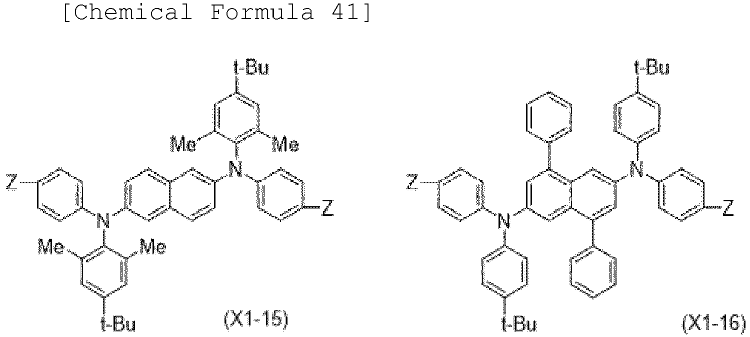 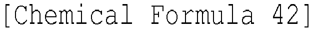 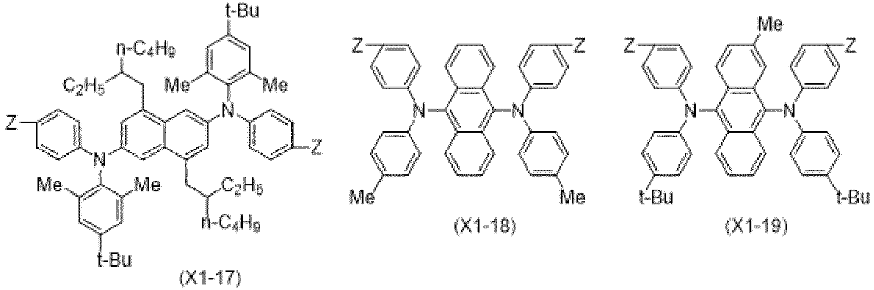 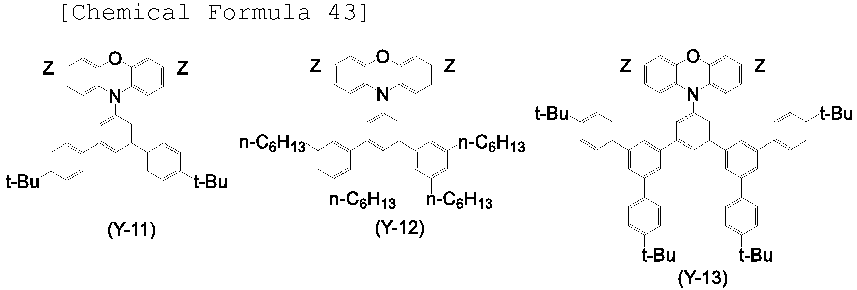 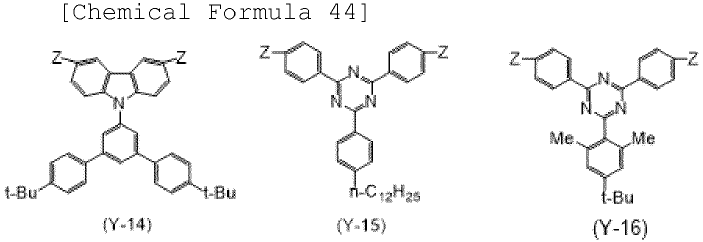 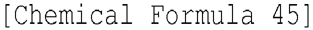 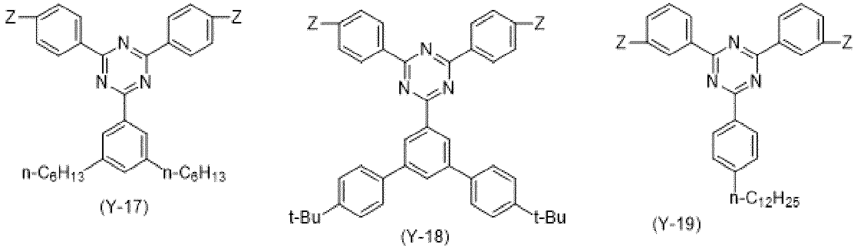 (wherein, Z represents a group selected from Group A of substituent and Group B of substituent. A plurality of Z may be the same or different.)

The examples and preferable range of Z are the same as the examples and preferable range of the group represented by Z¹, Z², Z³ or Z⁴.

### Solvent

The solvent includes, for example, water and organic solvents, and it is also possible to use water and an organic solvent in combination.

The organic solvent includes, for example, aromatic hydrocarbon solvents such as toluene, xylene, mesitylene and the like, ether solvents such as tetrahydrofuran, 1,4-dioxane, dimethoxyethane and the like, amide solvents such as N,N-dimethylacetamide, N,N-dimethylformamide and the like, alcohol solvents such as methanol, ethanol, ethylene glycol, isopropyl alcohol, propylene glycol, 2-methoxyethanol, 2-butoxyethanol and the like, ketone solvents such as acetone, methyl ethyl ketone, cyclopentanone, cyclohexanone, methyl amyl ketone, methyl isobutyl ketone, N-methyl-2-pyrrolidinone and the like, aliphatic hydrocarbon solvents such as pentane, hexane, heptane and the like, and halogenated hydrocarbon solvents such as chloroform and the like, and preferable are ether solvents, aromatic hydrocarbon solvents, amide solvents and ketone solvents, more preferable are ether solvents and aromatic hydrocarbon solvents, further preferable are aromatic hydrocarbon solvents.

The use amount of the solvent is usually 10 parts by weight to 100000 parts by weight, preferably 100 parts by weight to 50000 parts by weight, more preferably 200 parts by weight to 20000 parts by weight, with respect to 100 parts by weight of the total amount of a compound represented by the formula (M-1) and a compound represented by the formula (M-2).

The solvent may be used singly or in combination of two or more kinds thereof.

### Base

The base may be any of an inorganic base and an organic base, and is preferably an organic base.

The inorganic base includes, for example, aqueous solutions of inorganic acid salts of alkali metals, and preferable are aqueous solutions alkali metal carbonates such as sodium carbonate, potassium carbonate and the like, aqueous solutions of alkali metal hydroxides such as sodium hydroxide, potassium hydroxide and the like, and alkali metal phosphates such as potassium phosphate and the like.

The organic base includes, for example, tetraalkylammonium hydroxides, tetraalkylammonium carbonates, 1,5-diazabicyclo[4.3.0]non-5-ene, 1,8-diazabicyclo[5.4.0]undec-7-ene, 1,4-diazabicyclo[2.2.2]octane, dimethylaminopyridine, pyridine, trialkylamines, and alkylammonium fluorides such as tetraalkylammonium fluorides and the like, and preferable are tetraalkylammonium hydroxides, tetraalkylammonium carbonates, tetraalkylammonium dicarbonates and tetraalkylammonium fluorides, more preferable are tetraalkylammonium hydroxides, tetraalkylammonium carbonates and tetraalkylammonium dicarbonates, further preferable are tetraalkylammonium hydroxides.

The tetraalkylammonium hydroxide includes, for example, tetramethylammonium hydroxide, tetraethylammonium hydroxide, tetrapropylammonium hydroxide, benzyltrimethylammonium hydroxide, tetrabutylammonium hydroxide, phenyltrimethylammonium hydroxide, (C₅H₁₁)₄NOH, (C₁₆H₃₃)(CH₃)₃NOH, (C₁₆H₃₃)(CH₃)₃NOH, (C₈H₁₇)₃(CH₃)NOH, (C₈H₁₇)₂(C₁₀H₂₁)(CH₃)NOH, (C₈H₁₇)(C₁₀H₂₁)₂(CH₃)NOH, (C₁₀H₂₁)₃(CH₃)NOH, (C₈H₁₇)₄NOH and benzyltriethylammonium hydroxide.

The tetraalkylammonium carbonate includes, for example, tetramethylammonium carbonate, tetraethylammonium carbonate, tetrapropylammonium carbonate, benzyltrimethylammonium carbonate, tetrabutylammonium carbonate and phenyltrimethylammonium hydroxide.

The tetraalkylammonium dicarbonate includes, for example, tetramethylammonium bicarbonate, tetraethylammonium bicarbonate, tetrapropylammonium bicarbonate, benzyltrimethylammonium bicarbonate, tetrabutylammonium bicarbonate and phenyltrimethylammonium bicarbonate.

The use amount of the base is usually 0.5 mol to 100 mol, preferably 0.5 mol to 75 mol, more preferably 0.5 mol to 50 mol, with respect to 1 mol of the total amount of a compound represented by the formula (M-1) and a compound represented by the formula (M-2).

The base may be used singly or in combination of two or more kinds thereof.

### Phase transfer catalyst

The phase transfer catalyst may be added in a first step or a second step, or may be added in both a first step and a second step, for the purpose of improving reactivity.

The phase transfer catalyst includes, for example, ammonium compounds, phosphonium salts and macrocyclic polyethers, and ammonium compounds are preferable.

The ammonium compound includes, for example, tetrabutylammonium fluoride, tetrabutylammonium chloride, tetrabutylammonium bromide, tetrabutylammonium iodide, tetrapentylammonium fluoride, tetrapentylammonium chloride, tetrapentylammonium bromide, tetrapentylammonium iodide, (C₁₆H₃₃)(CH₃)₃NCl, (C₈H₁₇)₃(CH₃)NCl, (C₈H₁₇)₂(C₁₀H₂₁)(CH₃)NCl, (C₈H₁₇)(C₁₀H₂₁)₂(CH₃)NCl, (C₁₀H₂₁)₃(CH₃)NCl, (C₈H₁₇)₄NBr, benzyltriethylammonium chloride and cetylpyridinium chloride, and preferable are tetrabutylammonium bromide and tetrapentylammonium bromide.

The use amount of the phase transfer catalyst is usually 0.001 mol to 50 mol, preferably 0.005 mol to 10 mol, more preferably 0.01 mol to 1 mol, with respect to 1 mol of the total amount of a compound represented by the formula (M-1) and a compound represented by the formula (M-2).

The phase transfer catalyst may be used singly or in combination of two or more kinds thereof.

### Reaction conditions

In the first step, the reaction temperature of components is usually -100°C to 200°C, preferably 0°C to 150°C, more preferably 50°C to 100°C.

In the first step, the reaction time is usually 1 hour to 96 hours, preferably 2 hours to 48 hours.

In the first step, the reaction pressure is usually atmospheric pressure.

In the first step, the stirring power of mixing is usually 0.001 kW/m³ to 10 kW/m³, preferably 0.01 kW/m³ to 2 kW/m³.

In the first step, the order of mixing is not restricted.

In the first step, the oxygen concentration in the reaction is preferably 0.5% or less, more preferably 0.2% or less, further preferably 0.05% or less.

If the molecular weight of the compound obtained in the first step is measured every 30 minutes from the start of the reaction, the first step is preferably terminated when the variation of the molecular weight compared to the molecular weight obtained in the immediately preceding measurement becomes 40% or less, more preferably terminated when the variation becomes 20% or less, further preferably terminated when the variation becomes 5% or less, since the halogen content of the polymer compound can be reduced sufficiently.

### [Second step]

The second step is a step of reacting the above-described reaction product and a compound represented by the formula (M-3), in the presence of a second palladium compound different from the first palladium compound, to obtain a polymer compound. The reaction conditions are the same as the contents explained for the first step. It is preferable that the second step is conducted in the presence of the first palladium used in the first step.

In the second step, it is preferable to execute a step of mixing the resultant polymer compound (coarse product) and water to obtain a solution and separating the solution, a step of mixing the resultant polymer compound (coarse product) and a lower alcohol such as methanol and the like to cause deposition of a precipitate, isolating the precipitate by filtration, then, drying it, or other steps. The polymer compound thus obtained is preferably further purified by re-precipitation, continuous extraction with a Soxhlet extractor, adsorption treatment such as column chromatography, body feed and the like, or other means.

### Second palladium compound

The examples and preferable range of the second palladium compound are the same as the examples and preferable range of the first palladium compound, excepting points described later.

The ligand of the second palladium compound is preferably a dialkylarylphosphine type monodentate ligand, an alkyldiarylphosphine type monodentate ligand, a trialkylphosphine type monodentate ligand, a dialkylheteroarylphosphine type monodentate ligand or a carbene ligand, more preferably a dialkylarylphosphine type monodentate ligand, a trialkylphosphine type monodentate ligand or a dialkylheteroarylphosphine type monodentate ligands, further preferably a ligand represented by the formula (14) to the formula (17), particularly preferably a ligand represented by the formula (14). 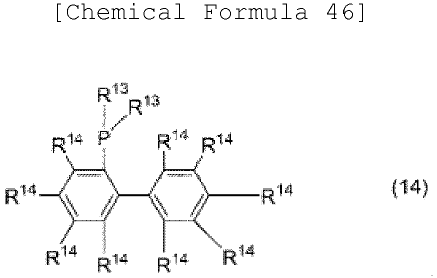 (wherein, R¹³ represents an alkyl group optionally having a substituent. R¹⁴ represents a hydrogen atom, an alkyl group, an alkoxy group, an amino group, a substituted amino group or a group represented by the formula: -SO₃Na, and these groups optionally have a substituent. A plurality of R¹³ and R¹⁴ may be the same or different at each occurrence.)

The compound represented by the formula (14) includes, for example, 2-dicyclohexylphosphino-2',6'-diisopropoxybiphenyl, 2-dicyclohexylphosphino-2'-(N,N-dimethylamino)biphenyl, 2-(dicyclohexylphosphino)-3,6-dimethoxy-2',4',6'-triisoprop yl-1,1'-biphenyl, 2-dicyclohexylphosphino-2' ,6'-dimethoxybiphenyl, 2-dicyclohexylphosphino-2' ,4' ,6'-triisopropylbiphenyl, (2-biphenyl)dicyclohexylphosphine, (2-biphenyl)di-tert-butylphosphine and 2-dicyclohexylphosphino-2'-methylbiphenyl, and preferable are 2-(dicyclohexylphosphino)-3,6-dimethoxy-2',4',6'-triisoprop yl-1,1'-biphenyl, 2-dicyclohexylphosphino-2',6'-dimethoxybiphenyl and 2-dicyclohexylphosphino-2',4',6'-triisopropylbiphenyl. 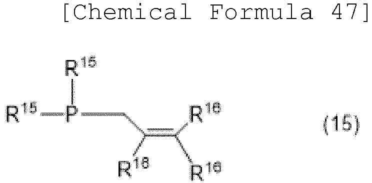 (wherein, R¹⁵ represents an alkyl group optionally having a substituent. R¹⁶ represents a hydrogen atom or an alkyl group optionally having a substituent. A plurality of R¹⁵ and R¹⁶ may be the same or different at each occurrence.)

The compound represented by the formula (15) includes, for example, di-tert-butyl(2-butenyl)phosphine and di-tert-butyl(3-methyl-2-butenyl)phosphine, and di-tert-butyl(2-butenyl)phosphine is preferable. 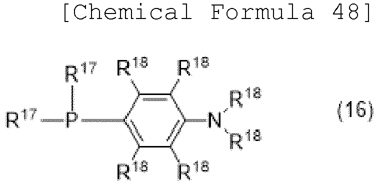 (wherein, R¹⁷ represents an alkyl group optionally having a substituent. R¹⁸ represents a hydrogen atom, an alkyl group, an alkoxy group or an aryloxy group, and these groups optionally have a substituent. A plurality of R¹⁷ and R¹⁸ may be the same or different at each occurrence.)

The compound represented by the formula (16) includes, for example, (4-dimethylaminophenyl)di-tert-butylphosphine, (4-dimethylaminophenyl)dicyclohexylphosphine and (4-dimethylaminophenyl)dicyclopentylphosphine, and (4-dimethylaminophenyl)di-tert-butylphosphine is preferable. 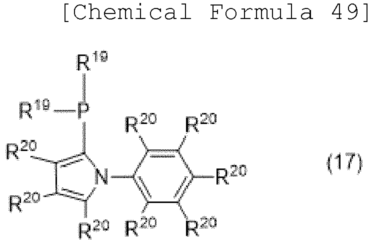 (wherein, R¹⁹ represents an alkyl group optionally having a substituent. R²⁰ represents a hydrogen atom, an alkyl group, an alkoxy group, an aryloxy group or a monovalent heterocyclic group, and these groups optionally have a substituent. A plurality of R¹⁹ and R²⁰ may be the same or different at each occurrence.)

The compound represented by the formula (17) includes, for example, 2-di-tert-butylphosphino-1-phenyl-1H-pyrrole, 2-dicyclohexylphosphino-1-phenyl-1H-pyrrole, 2-diethylphosphino-1-phenyl-1H-pyrrole, 2-dibutylphosphino-1-phenyl-1H-pyrrole and 2-dicyclopentylphosphino-1-phenyl-1H-pyrrole, and preferable are 2-di-tert-butylphosphino-1-phenyl-1H-pyrrole and 2-dicyclohexylphosphino-1-phenyl-1H-pyrrole.

The second palladium compound includes, for example, chloro(2-dicyclohexylphosphino-2',6'-diisopropoxy-1,1'-biph enyl)[2-(2-aminoethyl)phenyl]palladium, chloro(2-dicyclohexylphosphino-2',6'-dimethoxybiphenyl) [2-( 2-aminoethyl)phenyl]palladium, chloro(2-dicyclohexylphosphino-2',4',6'-triisopropyl-1,1'-b iphenyl)[2-(2-aminoethyl)phenyl]palladium, chloro(2-dicyclohexylphosphino-1,1'-biphenyl) [2-(2'-amino-1 ,1'-biphenyl)]palladium, chloro(2-dicyclohexylphosphino-2',6'-diisopropoxy-1,1'-biph enyl)[(2-(2'-amino-1,1'-biphenyl)]palladium, chloro(2-dicyclohexylphosphino-2',6'-dimethoxybiphenyl) [(2-(2'-amino-1,1'-biphenyl)]palladium, chloro(2-dicyclohexylphosphino-2',4',6'-triisopropyl-1,1'-b iphenyl) [(2-(2'-amino-1,1'-biphenyl)]palladium, [(2-dicyclohexylphosphino-3,6-dimethoxy-2',4',6'-triisoprop yl-1,1'-biphenyl)-2-(2'-amino-1,1'-biphenyl)palladium methanesulfonate, [(2-biphenyl)dicyclohexylphosphino(2'-amino-1-1'-biphenyl-2 -yl)]palladium methanesulfonate, (2-dicyclohexylphosphino-2',6'-diisopropoxy-1,1'-biphenyl) [ (2-(2'-amino-1,1'-biphenyl)]palladium methanesulfonate, (2-dicyclohexylphosphino-2',6'-dimethoxybiphenyl)[(2-(2'-am ino-1,1'-biphenyl)]palladium methanesulfonate, (2-dicyclohexylphosphino-2',4',6'-triisopropyl-1,1'-bipheny l) [(2-(2'-amino-1,1'-biphenyl)]palladium methanesulfonate, dichlorobis[di-tert-butyl(2-butenyl)phosphine]palladium, dichlorobis[di-tert-butyl(p-dimethylaminophenyl)phosphino]p alladium, di-tert-butylphosphine]palladium and dichlorobis[2-di-tert-butylphosphino]-1-phenyl-1H-pyrrole)p alladium.

The second palladium compound may be obtained commercially, may be synthesized by a ligand substitution reaction with a palladium precursor such as Pd(OAc)₂, Pd(dba)₂, Pd₂(dba)₃ and the like, or may be synthesized by mixing a palladium precursor and a compound to be a ligand in the system.

The second palladium compound may be added simultaneously with a compound represented by the formula (M-3) or may be added separately from a compound represented by the formula (M-3), and is preferably added separately from a compound represented by the formula (M-3).

The use amount of the second palladium compound is usually 0.00001 mol to 3 mol, with respect to 1 mol of the total amount of a compound represented by the formula (M-1) and a compound represented by the formula (M-2), and it is preferably 0.0001 mol to 3 mol, more preferably 0.0001 mol to 3 mol, further preferably 0.001 mol to 3 mol, since the halogen content in the polymer compound can be more reduced.

The second palladium compound may be used singly or in combination of two or more kinds thereof.

### Compound represented by the formula (M-3)

The aryl group represented by Ar³ is preferably a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group or a 4-phenylphenyl group.

The monovalent heterocyclic group represented by Ar³ is preferably a thienyl group, a pyrrolyl group, a furyl group, a pyridyl group, a piperidyl group, a quinolyl group, an isoquinolyl group, a pyrimidinyl group or a triazinyl group.

The group represented by Z⁵ is preferably a boronic acid residue or a boronic acid pinacol ester residue.

The compound represented by the formula (M-3) includes, for example, phenylboronic acid and phenylboronic acid pinacol ester, and phenylboronic acid is preferable.

The compound represented by the formula (M-3) is commercially available or can be produced according to a known method.

Th use amount of the compound represented by the formula (M-3) is usually 0.01 mol to 20 mol, preferably 0.05 mol to 15 mol, more preferably 0.1 mol to 10 mol, with respect to 1 mol of the total amount of a compound represented by the formula (M-1) and a compound represented by the formula (M-2).

The compound represented by the formula (M-3) may be used singly or in combination of two or more kinds thereof.

### [Other step]

In the production method of the present invention, other steps may be provided before the first step, between the first step and the second step, or after the second step.

<Polymer compound>

The polymer compound obtained by the production method of the present embodiment is a polymer compound having a constitutional unit represented by the formula (1) described above, a constitutional unit represented by the formula (2) described above and a structure represented by the formula (3) described above.

In the formula (1), the formula (2) and the formula (3), the examples and preferable range of Ar¹, Ar² and Ar³ are the same as the examples and preferable range described above.

In the above-described polymer compound, the constitutional unit represented by the formula (1), the constitutional unit represented by the formula (2) and the structure represented by the formula (3) each may be contained singly or in combination of two or more kinds thereof.

The above-described polymer compound includes, for example, polymer compounds EP-1 to EP4 described in Table 1. The "other" constitutional unit means a constitutional unit other than the polymer compound represented by the formula (1) and the constitutional unit represented by the formula (2).

**[Table 1]**

| Polymer compound | Constitutional unit and mole fraction thereof | | | | | | |
|---|---|---|---|---|---|---|---|
| | Formula (M-1) | | | Formula (M-2) | | | other |
| | Formula 1-11 to formula 1-46 | Formula X1-1 to formula X1-19 | Formula e Y11 to Y19 | Formula 1-11 to formula 1-46 | Formula X1-1 to formula X1-19 | Formula Y11 to Y19 | |
| | p | q | r | s | t | u | v |
| EP-1 | 0.1 to 99.9 | 0 | 0 | 0.1 to 99.9 | 0 | 0 | 0 to 30 |
| EP-2 | 0 | 0.1 to 99.9 | 0 | 0 | 0.1 to 99.9 | 0 | 0 to 30 |
| EP-3 | 0 | 0 | 0.1 to 99.9 | 0 | 0 | 0.1 to 99.9 | 0 to 30 |
| EP-4 | 0.1 to 99.9 | 0.1 to 99.8 | 0.1 to 99.8 | 0.1 to 99.8 | 0.1 to 99.8 | 0.1 to 99.8 | 0 to 30 |

| | | | | | | | |
|---|---|---|---|---|---|---|---|
| [in the table, p, q, r, s, t and u represent the mole fraction of each constitutional unit. p+q+r+s+t+u+v = 100 and 100 ≥ p+q+r+s+t+u ≥ 70.] | | | | | | | |

The polystyrene-equivalent number-average molecular weight (Mw) of the above-described polymer compound is preferably 1 × 10⁴ to 1 × 10⁶.

The above-described polymer compound may be any of a block copolymer, a random copolymer, an alternative copolymer or a graft copolymer, and may also be a copolymer in another form.

The content of a hydroxyl group contained in a polymer compound is the total amount of constitutional units having a hydroxyl group with respect to the total amount of constitutional units contained in the polymer compound. The content of a hydroxyl group contained in a polymer compound can be measured, for example, by proton NMR.

The content of a halogen atom contained in a polymer compound is the total amount of constitutional units having a halogen atom with respect to the total amount of constitutional units contained in the polymer compound. The content of a halogen atom contained in a polymer compound can be measured, for example, by elemental analysis.

### EXAMPLES

Embodiments of the present invention will be illustrated by examples below but the present invention is not limited to these examples.

### <Gel permeation chromatography (GPC) analysis conditions>

Measurement apparatus: HLC-8220GPC (manufactured by Tosoh Corp.)
Column: PLgel 10 µm MIXED-B (manufactured by Tosoh Corp.)
Column temperature: 40°C
Mobile phase: tetrahydrofuran
Flow rate: 1.5 mL/min
Detection wavelength: 228 nm

In the present example, compounds shown in Table 2 were used as raw material monomers, for synthesis of a polymer compound. These compounds were synthesized according to methods described in references shown in Table 2, respectively.

**[Table 2]**

| compound | Structural formula | References |
|---|---|---|
| 1-1 | 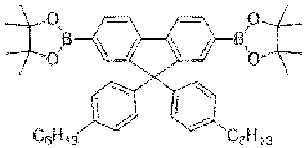 | Japanese Patent No. 5710993 |
| 1-2 | 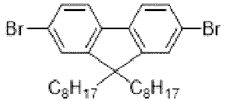 | International Publication WO 2002/045184 |
| 1-3 | 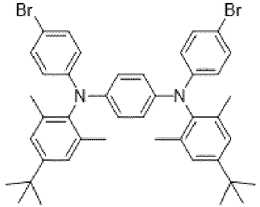 | Japanese Unexamined Patent Application Publication No. 2004-143419 |
| 1-4 | 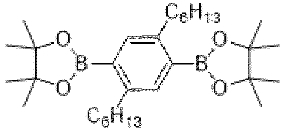 | Japanese Unexamined Patent Application Publication No. 2012-036388 |
| 1-5 | 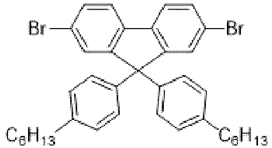 | Japanese Unexamined Patent Application Publication No. 2012-036388 |
| 1-6 | 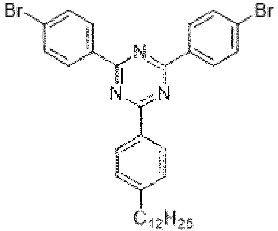 | Japanese Unexamined Patent Application Publication No. 2012-036388 |
| 1-7 | 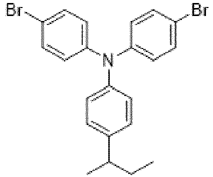 | International Publication WO 2002/045184 |
| 1-8 | 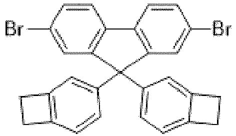 | Japanese Unexamined Patent Application Publication No. 2008-106241 |
| 1-9 | 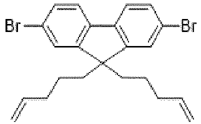 | Japanese Unexamined Patent Application Publication No. 2010-215886 |

### <Example 1>

### [First step]

An inert gas atmosphere was prepared in a reaction vessel, then, a compound 1-1 (6.52 mmol), a compound 1-2 (6.05 mmol), a compound 1-3 (0.67 mmol), dichlorobis[dicyclopentyl(2-methoxyphenyl)phosphine]palladi um (2.45 mg), tetrabutylammonium bromide (217 mg) and toluene (125 ml) were added. Thereafter, the oxygen concentration in the reaction vessel was adjusted to less than 0.01%, and the mixture was heated at 80°C. Thereafter, to this was added a 15 wt% tetramethylammonium hydroxide aqueous solution (66.7 g), and the mixture was stirred for 2 hours. In the first step, when the molecular weight of the reaction product was measured every 30 minutes from the start of the reaction, Mw of the reaction production at the time of 1.5 hours passed was 2.3 × 10⁵, while Mw of the reaction production at the time of 1 hour passed was 2.3 × 10⁵, that is the variation of the molecular weight was 1% or less, so it was judged that the first step was terminated.

### [Second step]

Thereafter, to this were added phenylboronic acid (411 mg) and (2-dicyclohexylphosphino-2',4',6'-triisopropyl-1,1'-bipheny l)[(2-(2'-amino-1,1'-biphenyl)]palladium methanesulfonate (28.5 mg), and the mixture was further stirred for 6 hours.

### [Other step]

Thereafter, the mixture was cooled down to room temperature, and the reaction liquid was diluted with toluene (550 ml) and washed with ion exchanged water (180 ml). The resultant toluene solution was washed with 10 wt% hydrochloric acid (180 ml) twice, with 3 wt% ammonia water (180 ml) twice and with ion exchanged water (180 ml) twice in this order, and purified by passing through an alumina column and a silica gel column.

The resultant toluene solution was dropped into methanol (2.7 L), stirred for 1 hour, then, the resultant solid was collected by filtration and dried, to obtain a polymer compound P-1. The polymer compound P-1 had an Mn of 7.9 × 10⁴ and an Mw of 2.2 × 10⁵. The polymer compound P-1 is considered to a copolymer in which constitutional units represented by the following formulae are copolymerized at a molar ratio of a:b:c = 50:45:5, according to charging raw materials. The oxygen concentration was measured using Pack Master (manufactured by Iijima Electronics Corporation, model number: RO103).

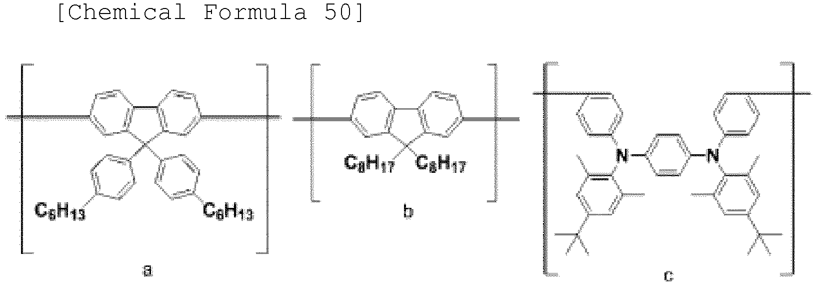

### <Example 2>

A polymer compound P-2 was obtained in the same manner as in Example 1 except that dichlorobis[tris(2-methoxyphenyl)phosphine]palladium (2.97 mg) was used instead of dichlorobis[dicyclopentyl(2-methoxyphenyl)phosphine]palladi um (2.45 mg) as the first palladium compound in Example 1. In the first step, when the molecular weight of the reaction product was measured every 30 minutes from the start of the reaction, Mw of the reaction production at the time of 1.5 hours passed was 1.5 × 10⁵, while Mw of the reaction production at the time of 1 hour passed was 1.5 × 10⁵, that is the variation of the molecular weight was 1% or less, so it was judged that the first step was terminated.

The polymer compound P-2 had an Mn of 5.1 × 10⁴ and an Mw of 1.5 × 10⁵.

The polymer compound P-2 is considered to be a copolymer having the same constitutional units and molar ratio as those of the polymer compound P-1, according to charging raw material.

### <Example 3>

### [First step]

An inert gas atmosphere was prepared in a reaction vessel, then, a compound 1-4 (5.30 mmol), a compound 1-5 (4.40 mmol), a compound 1-6 (1.10 mmol), dichlorobis[tris(2-methoxyphenyl)phosphine]palladium (1.46 mg), tetrabutylammonium bromide (179 mg) and toluene (50 ml) were added. Thereafter, the oxygen concentration in the reaction vessel was adjusted to less than 0.01%, and the mixture was heated at 80°C. Thereafter, to this was added a 15 wt% tetramethylammonium hydroxide aqueous solution (50.0 g), and the mixture was stirred for 4 hours. In the first step, when the molecular weight of the reaction product was measured every 30 minutes from the start of the reaction, Mw of the reaction production at the time of 4.0 hours passed was 9.6 × 10⁴, while Mw of the reaction production at the time of 3.5 hours passed was 9.4 × 10⁴, that is the variation of the molecular weight was 3% or less, so it was judged that the first step was terminated.

### [Second step]

Thereafter, to this were added phenylboronic acid (268 mg) and chloro(2-dicyclohexylphosphino-2',6'-dimethoxybiphenyl) [2-( 2-aminoethylphenyl)]palladium (20.0 mg), and the mixture was further stirred for 6 hours.

### [Other step]

Thereafter, the mixture was cooled down to room temperature, and the reaction liquid was diluted with toluene (350 ml) and washed with ion exchanged water (120 ml). The resultant toluene solution was washed with 10 wt% hydrochloric acid (120 ml) twice, with 3 wt% ammonia water (120 ml) twice and with ion exchanged water (120 ml) twice in this order, and purified by passing through an alumina column and a silica gel column.

The resultant toluene solution was dropped into methanol (3.0 L), and stirred for 1 hour, then, the resultant solid was collected by filtration and dried, to obtain a polymer compound P-3.

The polymer compound P-3 had an Mn of 3.0 × 10⁴ and an Mw of 9.8 × 10⁴.

The polymer compound P-3 is considered to be a copolymer in which constitutional units represented by the following formulae are copolymerized at a molar ratio of d:e:f = 50:40:10, according to charging raw material. The oxygen concentration was measured using Pack Master (manufactured by Iijima Electronics Corporation, model number: RO-103).

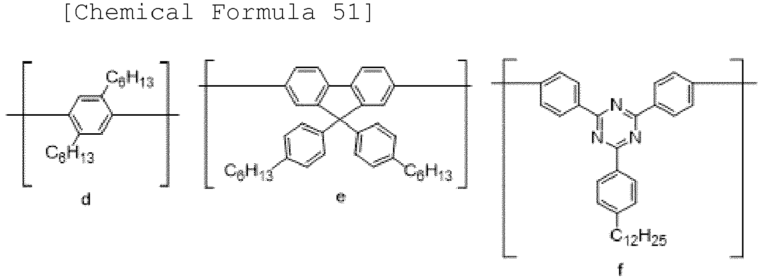

### <Example 4>

A polymer compound P-4 was obtained in the same manner as in Example 3 except that Pd(OAc)₂) (1.23 mg) and tri-o-tolylphosphine (6.70 mg) were used instead of dichlorobis[tris(2-methoxyphenyl)phosphine]palladium (1.46 mg) as the first palladium compound and dichlorobis[di-tert-butyl(p-dimethylaminophenyl)phosphino]p alladium (19.5 mg) was used instead of chloro(2-dicyclohexylphosphino-2',6'-dimethoxybiphenyl) [2-( 2-aminoethylphenyl)]palladium (20.0 mg) as the second palladium compound in Example 3.

In the first step, when the molecular weight of the reaction product was measured every 30 minutes from the start of the reaction, Mw of the reaction production at the time of 3.5 hours passed was 6.1 × 10⁴, while Mw of the reaction production at the time of 3 hours passed was 6.0 × 10⁴, that is the variation of the molecular weight was 2% or less, so it was judged that the first step was terminated.

The polymer compound P-4 had an Mn of 2.1 × 10⁴ and an Mw of 6.0 × 10⁴.

The polymer compound P-4 is considered to be a copolymer having the same constitutional units and molar ratio as those of the polymer compound P-3, according to charging raw materials.

### <Example 5>

### [First step]

An inert gas atmosphere was prepared in a reaction vessel, then, a compound 1-4 (7.09 mmol), a compound 1-7 (5.81 mmol), a compound 1-8 (0.73 mmol), a compound 1-9 (0.73 mmol), dichlorobis[tris(2-methoxyphenyl)phosphine]palladium (0.64 mg), tetrabutylammonium bromide (236 mg) and toluene (50 ml) were added. Thereafter, the oxygen concentration in the reaction vessel was adjusted to less than 0.01%, and the mixture was heated at 80°C. Thereafter, to this was added a 15 wt% tetramethylammonium hydroxide aqueous solution (50.0 g), and the mixture was stirred for 3 hours. In the first step, when the molecular weight of the reaction product was measured every 30 minutes from the start of the reaction, Mw of the reaction production at the time of 3.0 hours passed was 9.6 × 10⁴, while Mw of the reaction production at the time of 2.5 hours passed was 9.6 × 10⁴, that is the variation of the molecular weight was 1% or less, so it was judged that the first step was terminated.

### [Second step]

Thereafter, to this were added phenylboronic acid (354 mg) and chloro(2-dicyclohexylphosphino-2',6'-dimethoxybiphenyl) [2-( 2-aminoethylphenyl)]palladium (27.6 mg), and the mixture was further stirred for 6 hours.

### [Other step]

Thereafter, the mixture was cooled down to room temperature, and the reaction liquid was diluted with toluene (350 ml) and washed with ion exchanged water (120 ml). The resultant toluene solution was washed with 10 wt% hydrochloric acid (120 ml) twice, with 3 wt% ammonia water (120 ml) twice and with ion exchanged water (120 ml) twice in this order, and purified by passing through an alumina column and a silica gel column.

The resultant toluene solution was dropped into methanol (3.0 L), and stirred for 1 hour, then, the resultant solid was collected by filtration and dried, to obtain a polymer compound P-5.

The polymer compound P-5 had an Mn of 2.5 × 10⁴ and an Mw of 9.7 × 10⁴.

The polymer compound P-5 is considered to be a copolymer in which constitutional units represented by the following formulae are copolymerized at a molar ratio of g:h:i:j = 50:40:5:5, according to charging raw materials. The oxygen concentration was measured using Pack Master (manufactured by Iijima Electronics Corporation, model number: RO-103).

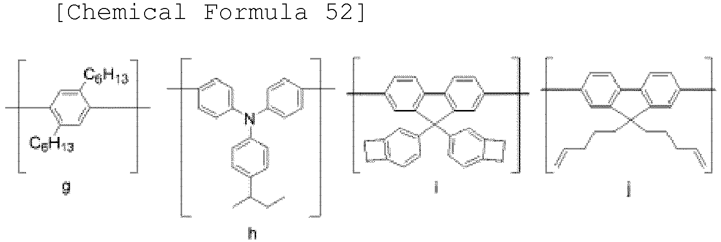

### <Comparative Example 1>

A polymer compound CP-1 was obtained in the same manner as in Example 1 except that dichlorobis[tris(2-methoxyphenyl)phosphine]palladium (2.97 mg) was used instead of dichlorobis[dicyclopentyl(2-methoxyphenyl)phosphine]palladi um (2.45 mg) as the first palladium compound and dichlorobis[tris(2-methoxyphenyl)phosphine]palladium (29.7 mg) was used instead of (2-dicyclohexylphosphino-2',4',6'-triisopropyl-1,1'-bipheny l)[(2-(2'-amino-1,1'-biphenyl)]palladium methanesulfonate (28.5 mg) as the second palladium compound in Example 1.

In the first step, when the molecular weight of the reaction product was measured every 30 minutes from the start of the reaction, Mw of the reaction production at the time of 1.5 hours passed was 1.5 × 10⁵, while Mw of the reaction production at the time of 1 hour passed was 1.5 × 10⁵, that is the variation of the molecular weight was 1% or less, so it was judged that the first step was terminated.

The polymer compound CP-1 had an Mn of 5.0 × 10⁴ and an Mw of 1.4 × 10⁵.

The polymer compound CP-1 is considered to be a copolymer having the same constitutional units and molar ratio as those of the polymer compound P-1, according to charging raw materials.

### <Comparative Example 2>

A polymer compound CP-2 was obtained in the same manner as in Example 1 except that (2-dicyclohexylphosphino-2',4',6'-triisopropyl-1,1'-bipheny l)[(2-(2'-amino-1,1'-biphenyl)]palladium methanesulfonate (2.85 mg) was used instead of dichlorobis[dicyclopentyl(2-methoxyphenyl)phosphine]palladi um (2.45 mg) as the first palladium compound in Example 1.

In the first step, when the molecular weight of the reaction product was measured every 30 minutes from the start of the reaction, Mw of the reaction production at the time of 1.5 hours passed was 1.6 × 10⁵, while Mw of the reaction production at the time of 1 hour passed was 1.6 × 10⁵, that is the variation of the molecular weight was 1% or less, so it was judged that the first step was terminated.

The polymer compound CP-2 had an Mn of 5.6 × 10⁴ and an Mw of 1.6 × 10⁵.

The polymer compound CP-2 is considered to be a copolymer having the same constitutional units and molar ratio as those of the polymer compound P-1, according to charging raw materials.

### <Measurement>

The polymer compounds P-1, P-2, CP-1 or CP-2 (20 mg) was dissolved in THF-d₈ (0.75 ml) and its proton NMR was measured, to determine the amount of a hydroxyl group in each polymer compound. For measurement of NMR, AV-600 (manufactured by BRUKER) was used.

For the polymer compounds P-1, P-2, CP-1 and CP-2, the amount of a hydroxyl group was determined by directly measuring proton of a hydroxyl group. Specifically, based on the proton NMR spectrum and the structures of charging raw materials used for synthesis of each polymer compound, the structure having a hydroxyl group generated during synthesis of each polymer compound was identified as the structure represented by the following formula and its content was quantified. The measurement results are shown in Table 3.

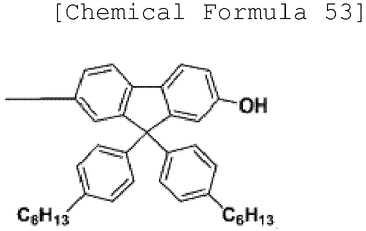

For the polymer compounds P-3, P-4 and P-5, the amount of a hydroxyl group was determined by directly measuring proton of a hydroxyl group. Specifically, based on the proton NMR spectrum and the structures of charging raw materials used for synthesis of each polymer compound, the structure having a hydroxyl group generated during synthesis of each polymer compound was identified as the structure represented by the following formula and its content was quantified. The measurement results are shown in Table 3.

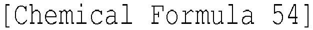

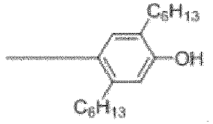

The polymer compounds P-1, P-2, P-3, P-4, P-5, CP-1 and CP-2 were subjected to elemental analysis, to determine the content of a bromine atom in each polymer compound. The content of a hydroxyl group in each polymer compound was determined, by performing NMR analysis by a method described in International Publication WO 2015/037521. The measurement results are shown in Table 3.

**[Table 3]**

| | Polymer compound | Content of hydroxyl group (mmol%) | Content of bromine atom (wt ppm) |
|---|---|---|---|
| Example 1 | P-1 | 3.3 | <0.1 |
| Example 2 | P-2 | 1.1 | 0.3 |
| Example 3 | P-3 | 3.3 | <0.1 |
| Example 4 | P-4 | 1.2 | 0.2 |
| Example 5 | P-5 | 0.9 | <0.1 |
| Comparative Example 1 | CP-1 | 1.1 | 0.7 |
| Comparative Example 2 | CP-2 | 12.8 | <0.1 |

### Industrial Applicability

A polymer compound in which the content of a halogen atom and the content of a hydroxyl group are sufficiently reduced can be efficiently produced by the production method of the present invention.

## Claims

1. A production method of a polymer compound having a constitutional unit represented by the formula (1), a constitutional unit represented by the formula (2) and a structure represented by the formula (3), comprising
a first step of reacting a compound represented by the formula (M-1) and a compound represented by the formula (M-2), in the presence of a solvent, a base and a first palladium compound, to obtain a reaction product, and
a second step of reacting said reaction product and a compound represented by the formula (M-3), in the presence of a second palladium compound different from the first palladium compound, to obtain a polymer compound:
[Chemical Formula 1]
Z¹-Ar¹-Z² (M-1)
Z³-Ar²-Z⁴ (M-2)
wherein,
Ar¹ and Ar² each independently represent an arylene group, a divalent heterocyclic group or a divalent aromatic amine residue, and these groups optionally have a substituent,
Z¹, Z², Z³ and Z⁴ each independently represent a group selected from Group A of substituent and Group B of substituent, and at least one of Z¹, Z², Z³ and Z⁴ is a group selected from Group A of substituent and at least one of them is a group selected from Group B of substituent:
<Group A of substituent>
a chlorine atom, a bromine atom, an iodine atom and a group represented by -O-S(=O)₂R^{C1} (wherein, R^{C1} represents an alkyl group or an aryl group, and these groups optionally have a substituent),
<Group B of substituent>
a group represented by -B(OR^{C2})₂ (wherein, R^{C2} represents a hydrogen atom, an alkyl group or an aryl group, and these groups optionally have a substituent, and a plurality of R^{C2} may be the same or different and may be combined together to form a ring together with oxygen atoms to which they are attached),
[Chemical Formula 2]
Ar³-Z⁵ (M-3)
wherein, Ar³ represents an aryl group or a monovalent heterocyclic group, and these groups optionally have a substituent, and Z⁵ represents a group selected from Group A of substituent and Group B of substituent,
[Chemical Formula 3]
⁅Ar¹⁆ (1)
⁅Ar²⁆ (2)
-Ar³ (3)
wherein, Ar¹, Ar² and Ar³ represent the same meaning as described above.

2. The polymer compound production method according to Claim 1, wherein
if the molecular weight of the reaction product obtained in the first step is measured every 30 minutes from the start of the reaction, the first step is terminated when the variation of the molecular weight of the reaction product obtained in the measurement 30 minutes earlier compared to the molecular weight of the reaction product obtained in the immediately preceding measurement becomes 40% or less.

3. The polymer compound production method according to Claim 1 or 2, wherein said first palladium compound and second palladium compound are each independently a palladium(0) complex or a palladium(II) complex.

4. The polymer compound production method according to any one of Claims 1 to 3, wherein said second palladium compound has a phosphine ligand.

5. The polymer compound production method according to any one of Claims 1 to 4, wherein said divalent aromatic amine residue is a group represented by the formula (X): 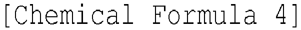 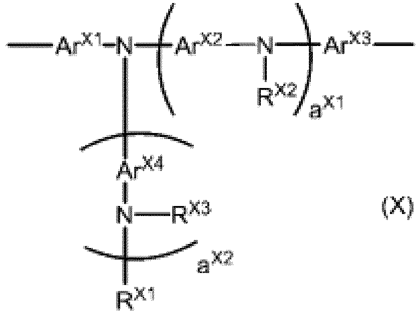 wherein,
a^{X1} and a^{X2} each independently represent an integer of 0 to 2,
Ar^{X1}, Ar^{X2}, Ar^{X3} and Ar^{X4} each independently represent an arylene group, a divalent heterocyclic group or a divalent group in which an arylene group and a divalent heterocyclic group are bonded directly, and these groups optionally have a substituent, and when a plurality of Ar^{X2} and Ar^{X4} are present, they may be the same or different at each occurrence,
R^{X1}, R^{X2} and R^{X3} each independently represent a hydrogen atom, an alkyl group, a cycloalkyl group, an aryl group, a monovalent heterocyclic group or a metal complex-containing group, and these groups optionally have a substituent, and when a plurality of R^{X2} and R^{X3} are present, they may be the same or different at each occurrence.

6. The polymer compound production method according to any one of Claims 1 to 5, wherein the second step is conducted in the presence of the first palladium used in the first step.
